# FASCICULE DE BREVET EUROPEEN

(11) **EP 2 018 687 B1**
(45) Date de publication et mention de la délivrance du brevet: **31.08.2011**
(21) Numéro de dépôt: 07766047.0
(22) Date de dépôt: 15.05.2007
(51) Int. Cl.: H01S 3/067, H01S 3/0941

(54) **DISPOSITIF LASER IMPULSIONNEL A FIBRE OPTIQUE DE FORTE PUISSANCE**
GEPULSTE FASEROPTISCHE LASERVORRICHTUNG MIT HOHER AUSGANGSLEISTUNG
HIGH-POWER FIBEROPTIC PULSED LASER DEVICE

(30) Priorité: 17.05.2006 FR 0651797
(43) Date de publication de la demande: 28.01.2009
(73) Titulaire: EOLITE Systems, 33600 Pessac (FR)
(72) Inventeur: SALIN, François, 33170 GRADIGAN (FR); METIVIER, Philippe, 33400 TALENCE (FR)
(74) Mandataire: Michelet, Alain
(86) Numéro de dépôt international: PCT/FR2007/051272
(87) Numéro de publication internationale: WO 2007/132124

(56) Documents cités:
- WO-A2-02/084821
- US-A- 6 014 249
- US-A- 6 137 812
- US-A1- 2004 213 302
- BALL G A ET AL: "NARROW-LINEWIDTH FIBER LASER WITH INTEGRATED MASTER OSCILLATOR-POWER AMPLIFIER" PROCEEDINGS OF THE OPTICAL FIBER COMMUNICATION CONFERENCE. SAN JOSE, FEB. 2 - 7, 1992, NEW YORK, IEEE, US, vol. CONF. 15, 2 février 1992 (1992-02-02), page 97, XP000341615 ISBN: 1-55752-222-7

## Description

L'invention concerne un dispositif laser impulsionnel à fibre optique de forte puissance.

Le principe de production d'impulsions lasers brèves par déclenchement d'un laser pompé en continu est connu de longue date. Elle consiste à stocker de l'énergie dans un milieu laser placé dans un résonateur optique maintenu dans un état bloquant.

Afin d'obtenir un rendement (rapport entre la puissance de pompe et la puissance émise par le laser) le plus important possible il est nécessaire d'utiliser un milieu laser dont la longueur permet l'absorption d'une part importante de la puissance de pompe.

Après une durée de pompage correspondant à la durée séparant l'émission de deux impulsions lasers successives, l'état du résonateur est alors basculé brusquement dans un état passant et un flux laser peut s'établir dans la cavité.

Le gain par passage étant important, l'intensité peut croître rapidement. Après un faible nombre d'aller-retour le rayonnement atteint une valeur maximale et décroît progressivement. L'émission laser prend alors la forme d'une impulsion dont la durée dépend de nombreux paramètres.

En particulier il est connu (A.E. Siegman: Lasers (University Science Books, Sausalito, CA, 1986)) que la durée de l'impulsion laser dépend directement de la longueur de la cavité et du gain par passage.

Des impulsions lasers d'une durée inférieure à la nanoseconde ont été obtenues avec des milieux lasers cristallins de longueur inférieure à 1 mm. Il faut alors utiliser des cristaux très fortement dopés pour absorber une large partie de l'onde de pompe émise par une diode laser et obtenir des rendements non négligeables et des énergies par impulsion raisonnables.

La puissance moyenne que l'on peut produire avec ces dispositifs lasers est néanmoins limitée par les effets thermiques induits dans le milieu laser.

Une solution classique consiste à faire suivre le dispositif laser générant des impulsions par un amplificateur qui n'a pas les mêmes contraintes de longueur et peut amplifier des impulsions brèves même si la longueur de l'amplificateur est importante. Cette solution appelée MOPA de l'anglais (Master Oscillator Power Amplifier) est forcément plus complexe et nécessite deux sources de pompage séparées.

Cette solution a été utilisée par de nombreux auteurs en particulier en associant des micro-lasers à solide produisant des impulsions lasers de faible puissance à des amplificateurs à fibre optique fournissant un fort gain et une grande puissance moyenne.

Cette solution a néanmoins l'inconvénient d'être complexe puisque plusieurs étages d'amplifications sont nécessaires afin d'atteindre des puissances compatibles avec des applications industrielles.

De plus il est impossible d'intégrer ce système puisque le micro-laser ne peut être soudé au reste des amplificateurs.

De la même façon l'oscillateur peut être une diode laser pulsée mais le nombre d'étages d'amplification augmente encore.

Par ailleurs il est nécessaire d'isoler ces étages d'amplification entre eux sous peine de voir une bonne partie de la puissance être émise sous forme d'un rayonnement continu.

Récemment une nouvelle technique de production d'impulsions nanosecondes basée uniquement sur des fibres optiques dopées par des ions Ytterbium a été présentée par Limpert et al (Conférence Advanced Solid State Photonics, Vienne, fevrier 2005 et XP010887669 : "Sub-10 ns Q-switched Yb-doped photonic crystal fiber laser" (QELS conference 2005, p.1322-1324)). Cette technique est basée sur l'utilisation d'une fibre optique courte, très fortement dopée, comme milieu amplificateur.

Il a aussi été montré qu'un tel système permet de produire des impulsions d'une durée de l'ordre de 10 ns y compris avec des déclencheurs (ou modulateurs optiques (Q-switch)) dont le temps de montée est largement supérieur à 10 ns.

Il est connu que la durée des impulsions est proportionnelle à la longueur du résonateur optique qui les produit. Pour obtenir des impulsions brèves il faut donc utiliser des résonateurs courts. Ceci impose des longueurs de fibre optique courtes dans le résonateur et par suite une faible absorption de la puissance de pompe donc un rendement médiocre.

Afin d'augmenter le rendement tout en maintenant une faible longueur de fibre on augmente habituellement le coefficient d'absorption de la pompe dans la structure, introduisant ainsi des densités de population excitée très élevées qui conduisent à une réduction de la durée de vie des fibres optiques.

Les solutions classiques imposent donc un compromis entre une fibre courte (courte durée d'impulsion) et longévité (trop grande densité d'ions excités pouvant introduire une évolution de la fibre).

Il est donc difficile d'obtenir en même temps un rendement élevé, une durée d'impulsion brève et une grande longévité de la fibre.

L'objectif de l'invention est donc de proposer un dispositif laser à fibre optique de forte puissance présentant un rendement élevé, une durée d'impulsion brève de l'ordre de la nanoseconde ou de quelques nanosecondes (<10ns), une grande longévité des fibres optiques, simple dans sa conception et pouvant se présenter sous une forme partiellement ou totalement intégrée.

A cet effet, l'invention concerne un dispositif laser impulsionnel à fibre optique de forte puissance comprenant :
- au moins une diode laser apte à émettre une onde de pompe,
- un résonateur optique déclenché apte à générer une onde laser comportant :
   o une extrémité très fortement réfléchissante pour l'onde laser et une extrémité partiellement réfléchissante apte à transmettre partiellement l'onde de pompe et à transmettre l'onde laser à l'extérieur du résonateur optique déclenché,
   o un milieu amplificateur constitué d'une première fibre optique apte à absorber l'onde de pompe et amplifier l'onde laser, disposé entre les deux extrémités réfléchissantes,
   o un modulateur optique apte à basculer d'un état bloquant à un état passant,
- un amplificateur optique constitué d'une deuxième fibre optique disposé tel que l'extrémité partiellement réfléchissante du résonateur optique déclenché se situe entre les deux fibres optiques, lesdites premières et deuxièmes fibres optiques étant du type fibre optique double gaine présentant un coeur, une gaine de pompage, une gaine de confinement et chacune une extrémité intérieure et une extrémité extérieure, les deux extrémités intérieures se faisant face,
- des premiers moyens de couplage optique aptes à coupler ladite onde de pompe à l'une des deux fibres optiques par leur extrémité extérieure,
- des seconds moyens de couplage optique disposés entre les deux fibres optiques aptes à coupler ladite onde de pompe à l'une des deux fibres optiques par leur extrémité intérieure, Selon l'invention :
   - le modulateur optique est un modulateur acousto-optique ou électro-optique,
   - le coeur dopé de la fibre optique par laquelle ladite onde de pompe est couplée par son extrémité extérieure est apte à absorber partiellement l'onde de pompe et à laisser une onde de pompe résiduelle à l'extrémité intérieure de ladite fibre optique,
   - les seconds moyens de couplage optique sont aptes à assurer simultanément le couplage de l'onde de pompe résiduelle et le couplage de l'onde laser issue du résonateur optique déclenché, et situés à l'extrémité intérieure de l'autre des deux fibres optiques,
   - ladite deuxième fibre optique présente une longueur supérieure à celle de la première fibre optique la rendant apte à amplifier l'onde laser issue du résonateur optique déclenché.

Dans différents modes de réalisation possibles, la présente invention concerne également les caractéristiques suivantes qui pourront être considérées isolément ou selon toutes leurs combinaisons techniquement possibles et apportent chacune des avantages spécifiques :
- les extrémités intérieures des premières et deuxièmes fibres optiques, l'extrémité partiellement réfléchissante et les seconds moyens de couplage optique sont assemblés entre eux de façon à former un ensemble monolithique,
- les premières et deuxièmes fibres optiques sont formées d'une fibre optique unique dans laquelle l'extrémité partiellement réfléchissante et les seconds moyens de couplage optique sont gravés ou photoinscrits, formant deux parties de fibre optique distinctes de longueurs différentes,
- l'extrémité partiellement réfléchissante et le modulateur optique forment un modulateur intégré dans les fibres optiques comprenant une commande électrique de façon à contrôler la réflectivité dudit modulateur, ledit modulateur intégré étant disposé entre les premières et deuxièmes fibres optiques,
- l'extrémité partiellement réfléchissante comprend un réseau de Bragg,
- l'extrémité fortement réfléchissante et les premiers moyens de couplage optique forment un réflecteur total intégré à l'extrémité externe de la première fibre optique, ledit réflecteur total comprenant un réseau de Bragg,
- les seconds moyens de couplage optique sont des moyens mécaniques de maintien d'extrémité de fibre optique aptes à rapprocher les extrémités intérieures des deux fibres optiques qui se font face,
- le dispositif laser impulsionnel à fibre optique comprend :
   o deux diodes lasers émettant chacune une onde de pompe et,
   o deux premiers moyens de couplage optique, l'un des premiers moyens de couplage optique étant apte à coupler l'une des ondes de pompe sur l'extrémité extérieure de la première fibre optique et l'autre des premiers moyens de couplage optique étant apte à coupler l'autre onde de pompe sur l'extrémité extérieure de la deuxième fibre optique,
- au moins une des deux fibres optiques (6, 10) est du type fibre photonique,
- le coeur des premières et deuxièmes fibres optiques présente un diamètre supérieur à 30 µm,
- le dispositif laser impulsionnel à fibre optique comprend un moyen polarisant et un moyen de stabilisation pour rigidifier les fibres optiques de façon à obtenir des impulsions lasers polarisées.

L'invention sera décrite plus en détail en référence aux dessins annexés dans lesquels :
- La figure 1 représente un dispositif laser à fibre optique de forte puissance selon un mode de réalisation de l'invention ;
- La figure 2 représente le dispositif laser à fibre optique ci-dessus de façon plus détaillée ;
- La figure 3 représente un mode de réalisation du dispositif laser à fibre optique avec une diode laser injectant une onde de pompe dans la zone d'amplification du dispositif laser ;
- La figure 4 représente un mode de réalisation du dispositif laser à fibre optique comprenant deux diodes lasers ;
- La figure 5 représente un autre mode de réalisation possible dans lequel le dispositif laser est partiellement intégré ;
- La figure 6 représente un autre mode de réalisation possible dans lequel le dispositif laser est totalement intégré ;
- La figure 7 représente un autre mode de réalisation dans lequel les fibres optiques sont séparées par une mince couche d'air,

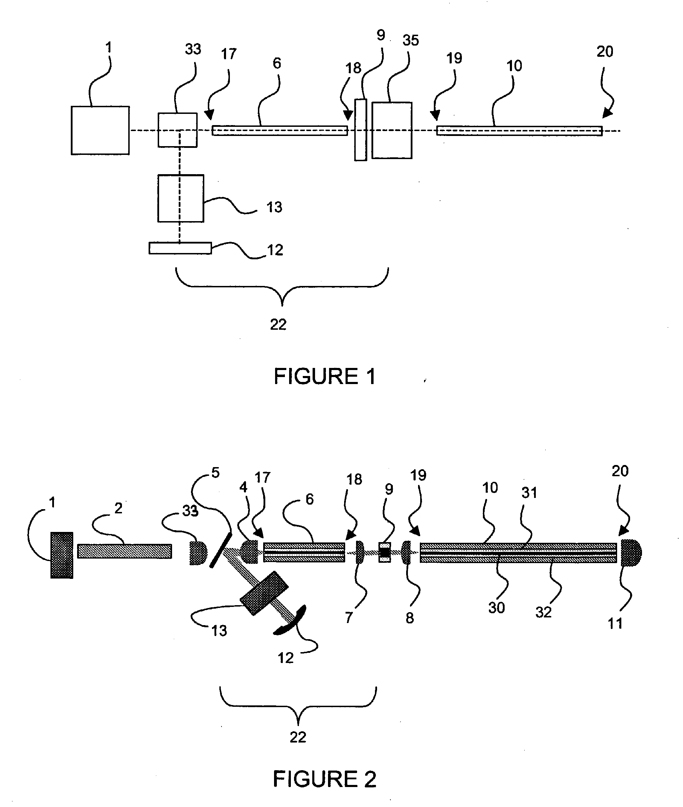

La figure 1 représente un dispositif laser à fibre optique de forte puissance selon un mode de réalisation de l'invention.

Ce dispositif comprend une diode laser 1 apte à émettre une onde de pompe. Il peut comprendre plusieurs diodes lasers 1.

L'onde de pompe est injectée dans un résonateur optique déclenché 22 apte à générer une onde laser.

Le résonateur optique déclenché 22 comporte une extrémité très fortement réfléchissante 12, c'est-à-dire totalement ou quasiment réfléchissante, et une extrémité partiellement réfléchissante 9 apte à transmettre partiellement l'onde de pompe et l'onde laser à l'extérieur du résonateur optique déclenché 22.

Il comprend un milieu amplificateur constitué d'une première fibre optique 6 apte à absorber partiellement l'onde de pompe et à amplifier l'onde laser, disposé entre les deux extrémités réfléchissantes 9 et 12.

Il peut comprendre avantageusement un modulateur optique 13 apte à basculer d'un état bloquant à un état passant pour obtenir des impulsions lasers.

De façon classique, le modulateur optique 13 peut être un modulateur acousto-optique ou électro-optique par exemple.

Il comprend un amplificateur optique constitué d'une deuxième fibre optique 10, disposé à l'extérieur du résonateur optique déclenché 22.

L'extrémité partiellement réfléchissante 9 est disposée entre les premières 6 et deuxièmes 10 fibres optiques qui présentent chacune une extrémité intérieure 18, 19 et une extrémité extérieure 17, 20. Les deux extrémités intérieures (18, 19) sont disposées l'une face à l'autre.

L'extrémité extérieure 17 de la première fibre optique 6 est apte à recevoir une onde de pompe émise par une diode laser 1 à travers des premiers moyens de couplage optique 33. L'extrémité extérieure 17 et de la première fibre optique 6 et l'extrémité extérieure 20 de la deuxième fibre optique 10 sont séparées par les deux fibres optiques 6 et 10.

Les premiers moyens de couplage optique 33 peuvent comprendre une première lentille 3, un miroir dichroïque 5 et une deuxième lentille 4, comme représentés sur la figure 2.

L'extrémité partiellement réfléchissante 9 est partiellement réfléchissante à la longueur d'onde laser.

Elle doit permettre un transfert des ondes lasers et de pompe le traversant. Elle peut être constituée d'une simple lame d'air, de verre ou de silice ou une lame traitées à l'aide de couches diélectriques ou un miroir semi-réfléchissant ou un réseau de Bragg massif inscrit dans un substrat de verre ou de tout autre système réfléchissant.

L'extrémité partiellement réfléchissante 9 délimite une première zone "oscillateur" du côté de la première fibre optique 6, dans laquelle l'onde laser va se construire.

Du coté de la deuxième fibre optique 10, l'extrémité partiellement réfléchissante 9 délimite une zone « amplificatrice » dans laquelle l'onde laser va s'amplifier.

Le dispositif laser à fibre optique peut comprendre des seconds moyens de couplage optique 35 disposés entre les deux fibres optiques 6 et 10.

Comme représenté sur la figure 2, les premières 6 et deuxièmes 10 fibres optiques sont du type fibre optique double gaine présentant un coeur 30, une gaine de pompage 31 et une gaine de confinement 32.

Le coeur dopé 30 de la fibre optique 6 par laquelle l'onde de pompe est couplée par son extrémité extérieure 17 est apte à absorber partiellement l'onde de pompe et à laisser une onde de pompe résiduelle à l'extrémité intérieure 18 de l'autre fibre optique 6.

L'extrémité intérieure 18 de la première fibre optique 6 et l'extrémité intérieure 19 de la deuxième fibre optique 10 sont aptes à se transmettre simultanément l'onde de pompe résiduelle et l'onde laser issu du résonateur 22 à travers des seconds moyens de couplage optique 35.

Les seconds moyens de couplage optique 35 sont optimisés pour coupler simultanément l'onde de pompe résiduelle issu de la gaine de pompage 31 de la fibre optique 6 vers la gaine de pompage 31 de l'autre fibre optique 10 et l'onde laser issue du coeur 30 de la fibre optique 6 dans le coeur dopé 30 de l'autre fibre optique 10.

Les seconds moyens de couplage optique 35 peuvent comprendre une première lentille de collimation 7 disposée entre la première fibre optique 6 et l'extrémité partiellement réfléchissante 9 et une deuxième lentille de collimation 8 disposée entre l'extrémité partiellement réfléchissante 9 et la deuxième fibre optique 10.

L'extrémité partiellement réfléchissante 9 peut être située entre la première lentille de collimation 7 et la deuxième lentille de collimation 8 ou entre une des extrémités intérieures 18, 19 des fibres 6, 10 et l'un de ces deux éléments optiques 7, 8.

Les fibres optiques 6 et 10 sont des fibres lasers composites capables de produire du gain à la longueur d'onde laser d'intérêt.

Le coeur 30 de ces fibres optiques 6 et 10 présente un diamètre compris entre 5 et 200 microns. Il est dopé par un ion pris dans la famille des terres rares (Ytterbium, Neodyme, Erbium, Thulium, Holmium...). De façon préférentielle, il est dopé par des ions Ytterbium. Il permet le guidage d'une onde à la longueur d'onde laser.

Ce guidage est préférentiellement monomode mais peut être multimode.

Le coeur 30 des fibres optiques 6 et 10 est entouré par une gaine de pompage 31 dont le diamètre est compris entre 1 et 10 fois celui du coeur 30.

La gaine de pompage 31 peut être homogène ou contenir des micro-structurations afin de garantir un guidage dans le coeur 30 de l'onde laser. Les fibres optiques 6 et 10 sont alors de type fibre photonique.

La gaine de pompage 31 est entourée par une gaine de confinement 32 composée d'un matériau de faible indice ou d'une structure de type « air clad ». La gaine de pompage 31 doit assurer le guidage d'une onde à la longueur d'onde de pompe correspondant à une absorption de l'ion dopant du coeur 30.

L'ouverture numérique de cette gaine de pompage 31 doit être la plus grande possible.

L'ensemble peut être entouré d'une gaine mécanique dont le rôle est d'assurer le maintien mécanique des fibres.

Les fibres optiques 6 et 10 sont composées préférentiellement de verre ou de silice et d'air.

Les fibres optiques 6 et 10 peuvent avoir des diamètres de coeur et de gaine différents mais le système fonctionnera de façon avantageuse si les ratio entre diamètre de coeur et diamètre de gaine sont très proches dans la première fibre optique 6 et la deuxième fibre optique 10.

Les ondes de pompe sont incidentes sur l'extrémité extérieure 17 de la première fibre optique 6. Elles peuvent être également injectées le long de cette première fibre optique 6 dans la gaine de pompe 31 par le premier moyen de couplage optique 33.

La figure 2 représente un mode de réalisation du dispositif laser à fibre optique de façon plus détaillée avec lequel il est possible de mieux comprendre le fonctionnement du dispositif.

Une onde de pompe est émise par la diode laser 1. Elle est injectée dans la première fibre optique 6 à travers les premiers moyens de couplage optique 33.

L'onde de pompe peut être préalablement émise dans une fibre de guidage 2 disposée entre la diode laser 1 et les premiers moyens de couplage optique 33.

Plus précisément, l'onde de pompe est collimatée par la première lentille 3. Elle traverse le miroir dichroïque 5 et est focalisée sur l'extrémité extérieure 17 de la première fibre optique 6 par la deuxième lentille 4.

Une partie de l'onde de pompe est absorbée lors de sa propagation dans la première fibre optique 6. Le coeur dopé 30 de la fibre optique 6 par laquelle l'onde de pompe est couplée par son extrémité extérieure 17 est apte à absorber partiellement l'onde de pompe et à laisser sortir une onde de pompe résiduelle à l'extrémité intérieure 18 de cette fibre optique 6.

La structure double gaine de la première fibre optique 6 permet à l'onde de pompe d'être guidée.

A la sortie de la première fibre optique 6, c'est-à-dire à l'extrémité intérieure 18 de la première fibre optique 6, l'onde de pompe résiduelle et l'onde laser sont collimatées à nouveau par la première lentille de collimation 7 pour traverser l'extrémité partiellement réfléchissante 9 qui peut être un miroir partiellement réfléchissant. L'onde de pompe résiduelle et l'onde laser sont ensuite couplées sur l'extrémité intérieure 19 de la deuxième fibre optique 10 amplificatrice par la deuxième lentille de collimation 8.

La longueur de la deuxième fibre optique 10 est choisie pour absorber une grande partie de l'onde de pompe incidente sur son extrémité intérieure 19.

L'extrémité très fortement réfléchissante 12 de la cavité laser du résonateur optique déclenché 22 renvoie vers la première fibre optique 6 tout ou partie du rayonnement émis par cette dernière. L'extrémité très fortement réfléchissante 12 peut être un miroir.

Le miroir dichroïque 5 est préférentiellement totalement réfléchissant à la longueur d'onde laser et transparent à la longueur d'onde de l'onde de pompe.

La longueur d'onde de pompe est choisie parmi les longueurs d'onde absorbées par les fibres optiques 6 et 10.

La deuxième lentille 4, la première lentille de collimation 7 et la deuxième lentille de collimation 8 sont choisies de façon à avoir une ouverture numérique au moins aussi importante que celle des gaines de pompe 31 des fibres optiques 6 et 10.

Lorsque l'onde de pompe produit par la diode laser 1 est absorbée dans les fibres optiques 6 et 10, elle crée une inversion de population.

Si l'extrémité très fortement réfléchissante 12 et l'extrémité partiellement réfléchissante 9 sont correctement disposées, un effet laser se produit dans la cavité résonante ainsi formée.

L'onde de pompe résiduelle est partiellement transmise par l'extrémité partiellement réfléchissante 9 et est injectée dans la deuxième fibre optique 10 par la deuxième lentille de collimation 8.

L'extrémité partiellement réfléchissante 9 et la deuxième lentille de collimation 8 sont choisies de façon à coupler simultanément le mode issu du coeur 30 de la première fibre optique 6 dans le coeur 30 de la deuxième fibre optique 10 ainsi que le rayonnement laser issu de la gaine de pompe 31 de la première fibre optique 6 vers la gaine de pompe 31 de la deuxième fibre optique 10 en garantissant un accord à la fois pour les dimensions et pour les ouvertures numériques.

L'onde laser est alors amplifiée par la deuxième fibre optique 10 qui est elle-même pompée par le résiduel de la pompe n'ayant pas été absorbée dans première fibre optique 6.

L'onde de pompe est très partiellement absorbée dans la première fibre optique 6 (5 à 50% et avantageusement moins de 20%). Le reste est absorbé dans la deuxième fibre optique 10 afin que l'onde de pompe soit totalement, ou presque, absorbée.

La valeur typique de l'absorption d'une onde de pompe par le coeur 30 doit être inférieure à 30 dB/m, valeur qui prend en compte le rapport des surfaces du coeur 30 et de la gaine 31.

De même la concentration locale d'ions terre rare dans le coeur 30 doit être la plus uniforme possible.

La longueur des fibres 6 et 10 est choisie afin d'assurer une absorption quasi complète de l'onde de pompe et permettre de produire des impulsions brèves de forte puissance ayant une durée de l'ordre de la nanoseconde ou de quelques nanosecondes (<10 ns).

La deuxième fibre optique 10 présente une longueur supérieure à celle de la première fibre optique 6. Cette longueur est adaptée pour que la deuxième fibre optique 10 absorbe une plus grande partie de l'onde de pompe par rapport à la première fibre optique 6.

Le dispositif laser à fibre optique permet de conserver des absorptions faibles dans la première fibre optique 6 tout en transférant néanmoins le maximum de puissance de pompe grâce à la deuxième fibre optique 10 amplificatrice qui absorbe toute la puissance de pompe que la première fibre optique 6 n'a pas absorbée.

La première fibre optique 6 peut donc avoir une longueur plus courte que la deuxième fibre optique 10 et doit permettre de produire des impulsions brèves. Ces impulsions sont amplifiées dans la deuxième fibre optique 10. La deuxième fibre optique 10 n'a plus de contrainte de longueur puisqu'elle n'est pas intégrée dans le résonateur optique déclenché 22 et peut donc présenter une absorption linéique faible donc être exempte de problèmes d'évolution dans le temps. On conserve ainsi à la fois la production d'impulsions brèves, le rendement élevé (puissance laser / puissance de pompe) et la longévité des fibres. L'absorption de l'onde de pompe est bien répartie entre les deux fibres optiques 6 et 10 évitant les effets thermiques et de vieillissement des fibres.

La longueur totale des fibres optiques 6 et 10 mises bout à bout est comprise entre 50 cm et 5 m.

On voit ainsi que quelle que soit la longueur de la première fibre optique 6 l'ensemble de la puissance de pompe peut être absorbée par l'ensemble des fibres optique 6 et 10. Il suffit pour cela que leur longueur combinée soit choisie pour être plus grande qu'une longueur d'absorption.

La longueur de la première fibre optique 6 est préférentiellement comprise entre 3 cm et 30 cm.

Elle possède un coeur 30 de gros diamètre compris entre 10 et 100 microns. Les ions excités sont donc d'une part peu nombreux (faible absorption) et d'autre part répartis au sein d'un volume important (large coeur). Leur densité est donc relativement faible. Le gain dans cette fibre courte est plus faible que ceux habituellement utilisées dans des lasers pulsés. Le gain relativement plus faible est compensé par un résonateur optique déclenché 22 de faible longueur optique. Des impulsions brèves sont alors produites.

La puissance de pompe qui n'est pas absorbée par la première fibre optique 6 est refocalisée par la première lentille de collimation 7 et la deuxième lentille de collimation 8 vers la deuxième fibre optique 10, comme dit précédemment.

Les caractéristiques de la première lentille de collimation 7 et de la deuxième lentille de collimation 8 sont calculées de façon à imager d'une part tout rayon issu de la gaine de confinement 31 de la première fibre optique 6 vers la gaine de confinement 31 de la deuxième fibre optique 10 en respectant les ouvertures numériques respectives, et d'autre part les modes propres de propagation issus du coeur 30 de la première fibre optique 6 vers les modes propres de propagation du coeur 30 de la deuxième fibre 10 avec un minimum de perte.

Le taux de dopage du coeur 30 des fibres optiques 6 et 10 est calculé pour éviter tout problème d'évolution dans le temps des fibres même sous un fort flux de pompage

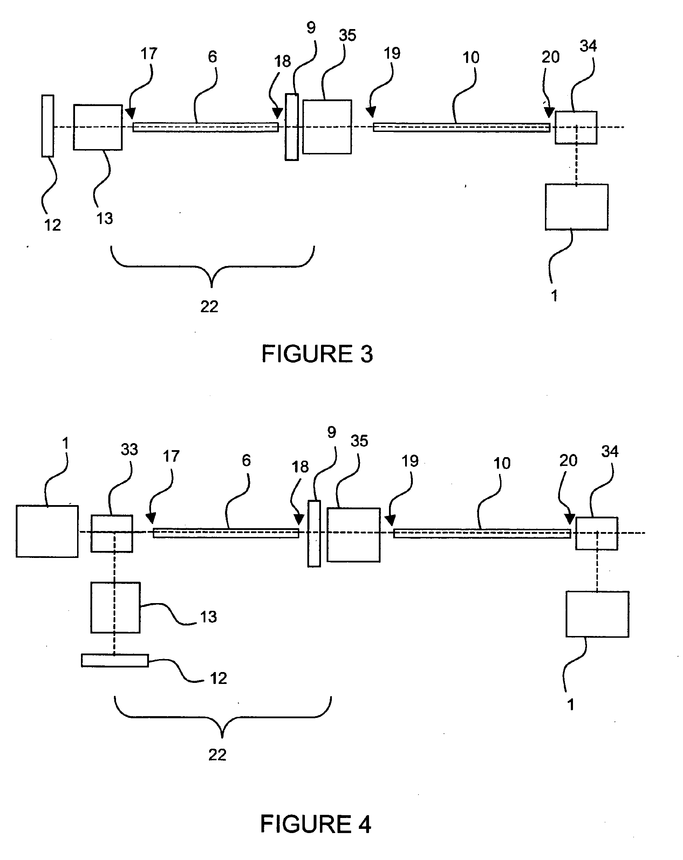

D'autres modes de réalisation sont envisageables comme le montre la figure 3.

L'onde de pompe peut être injectée par la diode laser 1 sur l'extrémité extérieure 20 de la deuxième fibre optique 10 par les premiers moyens de couplage optique 34 qui présentent les mêmes caractéristiques que dans l'exemple précédent.

L'onde de pompe est alors partiellement absorbée par la deuxième fibre optique 10 générant une onde de pompe résiduelle sortant à travers l'extrémité intérieure 19 de celle-ci. L'onde de pompe résiduelle est ensuite couplée sur l'extrémité intérieure 18 de la première fibre optique 6 par les seconds moyens de couplage optique 35.

Dans cet exemple, le modulateur optique 13, l'extrémité très fortement réfléchissante 12 et les premiers moyens de couplage optique 34 sont alignés avec les deux fibres optiques 6 et 10. Le modulateur optique 13 est placé face à l'extrémité extérieure 17 de la première fibre optique 6 et entre celle-ci et l'extrémité très fortement réfléchissante 12.

Les impulsions lasers ressortent du dispositif laser à travers les premiers moyens de couplage optique 34.

La figure 4 représente un autre mode de réalisation possible dans lequel le dispositif laser comprend deux premiers moyens de couplage optique 33, 34 et deux diodes lasers 1 émettant chacune une onde de pompe.

L'un des premiers moyens de couplage optique 33 est apte à coupler l'une des ondes de pompe sur l'extrémité extérieure 17 de la première fibre optique 6 et l'autre des premiers moyens de couplage optique 34 est apte à coupler l'autre onde de pompe sur l'extrémité extérieure 20 de la deuxième fibre optique 10.

Les impulsions lasers ressortent du dispositif laser à travers les premiers moyens de couplage optique 34 disposés face à l'extrémité extérieure 20 de la deuxième fibre optique 10.

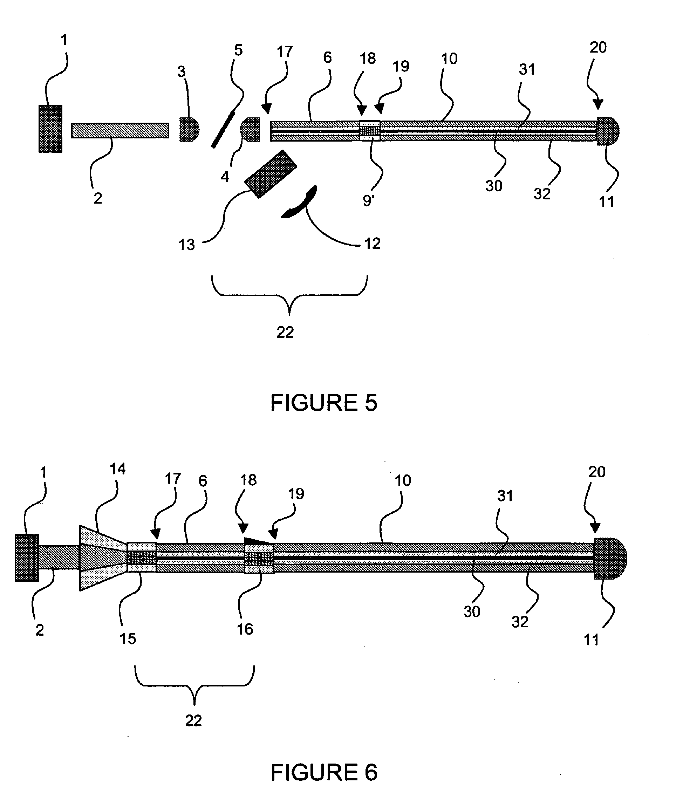

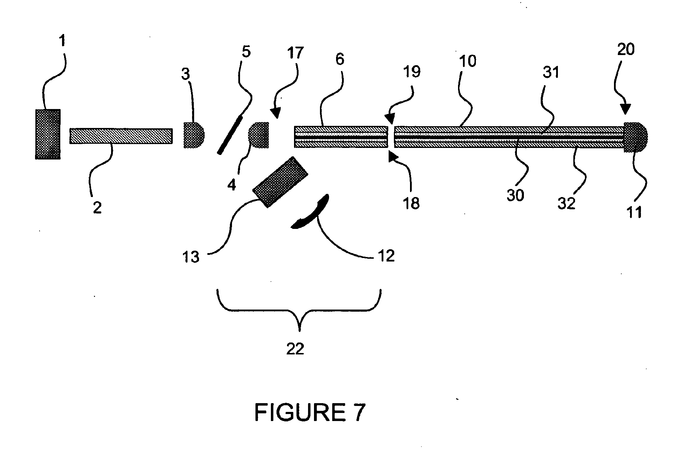

Les figures 5 et 7 représente deux autres modes de réalisation possible dans lequel le dispositif laser est partiellement intégré.

Sur la figure 5, les extrémités intérieures 18, 19 des premières 6 et deuxièmes 10 fibres optiques, l'extrémité partiellement réfléchissante 9 et les seconds moyens de couplage optique 35 sont assemblés entre eux de façon à former un ensemble monolithique, c'est-à-dire formé d'un seul bloc.

Dans un mode de réalisation particulier représenté sur la figure 7, les seconds moyens de couplage optique 35 peuvent être des moyens mécaniques de maintien d'extrémité de fibre optique aptes à rapprocher les extrémités intérieures 18, 19 des deux fibres optiques 6, 10 qui se font face. Les fibres optiques 6 et 10 peuvent être rapprochées l'une de l'autre à une distance inférieure à 100 microns. On retrouve entre les extrémités intérieures 18, 19 des deux fibres optiques 6, 10 seulement une mince lame d'air ou un matériau de faible indice (d'épaisseur inférieure à 100µm). Les extrémités 18 et 19 des deux fibres optiques 6, 10 sont maintenues alignées par les moyens mécaniques précités.

L'extrémité partiellement réfléchissante 9 peut être constituée d'au moins une des deux extrémités intérieures 18, 19 des fibres optiques 6, 10. Les extrémités intérieures 18, 19 sont éventuellement recouvertes d'un traitement optique partiellement réfléchissant pour l'onde laser.

Il est particulièrement avantageux pour des raisons de fiabilité et de coûts de réalisation de pouvoir intégrer le maximum de fonction dans les fibres optiques 6 ou 10.

L'extrémité partiellement réfléchissante 9 peut être un réflecteur de Bragg 9' comprenant un réseau de Bragg dont le coefficient de réflexion est typiquement compris entre 10 et 50% à la longueur d'onde de l'impulsion laser.

Ce réflecteur de Bragg 9' est inscrit dans le coeur 30 de la fibre optique 6 ou 10. Une continuité de guidage est assurée aussi bien pour l'onde de pompe que les impulsions lasers.

Les fibres optiques 6 et 10 et le réflecteur de Bragg 9' peuvent être soudés entre eux afin de former l'ensemble monolithique.

Selon un autre mode de réalisation, les premières 6 et deuxièmes 10 fibres optiques sont formées d'une fibre optique unique 6, 10 dans laquelle le réflecteur de Bragg 9' est gravé ou photo-inscrit, définissant deux zones 6 et 10. La plus courte étant l'équivalent de la première fibre optique 6 et la plus longue étant l'équivalent de la deuxième fibre optique 10.

Selon un autre mode de réalisation représenté sur la figure 6, l'extrémité partiellement réfléchissante 9 et le modulateur optique 13 sont combinés pour former un modulateur intégré 16 dans les fibres optiques 6 et 10. On obtient un dispositif laser monolithique totalement intégré.

Le modulateur intégré 16 peut comprendre un réseau de Bragg et une commande électrique de façon à contrôler sa réflectivité. On peut modifier sa réflectivité par un signal extérieur.

Le modulateur intégré 16 est disposé entre les premières 6 et deuxièmes 10 fibres optiques.

Le modulateur intégré 16 guide l'onde de pompe d'une fibre à l'autre.

Dans cette configuration, l'onde de pompe est couplée dans la première fibre optique 6 à l'aide d'une optique de couplage 14 ou d'un "entonnoir" (ou "taper" en anglais).

L'optique de couplage 14 adapte adiabatiquement le diamètre de la fibre de guidage 2 transportant l'onde de pompe émise par la diode laser 1 vers le diamètre de la gaine de pompe 31 de la première fibre optique 6.

L'extrémité très fortement réfléchissante 12 et les premiers moyens de couplage optique 33 peuvent être combinées pour former un réflecteur total 15 intégré à l'extrémité externe 17 de la première fibre optique 6.

Le réflecteur total 15 formé par un réseau de Bragg inscrit dans la première fibre optique 6 forme le miroir de fond de la cavité résonante et transmet l'onde de pompe.

L'ensemble des éléments optique 2, 14, 15, 6, 16 et 10 du dispositif laser est assemblé de façon à former un système monolithique. Ces éléments peuvent être soudés.

Plusieurs diodes lasers 1 peuvent être couplés dans la fibre grâce à un système de « pieuvres de tapers ».

Le modulateur intégré 16 peut être positionné ente l'extrémité extérieure 17 de la première fibre optique 6 et l'optique de couplage 14.

Le dispositif laser peut comprendre un moyen polarisant et un moyen de stabilisation pour rigidifier les fibres optiques 6, 10 de façon à obtenir des impulsions lasers polarisées. Le modulateur 13 peut être cet élément polarisant.

Les fibres optiques 6, 10 peuvent être rigidifiées soit de façon intrinsèque par l'emploi de fibres de type « rod-type fiber » ou par des moyens mécaniques externes à la fibre (support ou gaine mécanique par exemple). Ces moyens mécaniques peuvent être soit linéaires soit présenter un forme régulière compatible avec le soutien d'une fibre optique (cercle, spirale, portion de courbe...).

On obtient ainsi un dispositif laser à fibre optique de forte puissance présentant un rendement élevé, une durée d'impulsion brève de l'ordre de la nanoseconde, une grande longévité des fibres optiques, simple dans sa conception et pouvant se présenter sous une forme partiellement ou totalement intégrée.

## Revendications

1. Dispositif laser impulsionnel à fibre optique de forte puissance comprenant :
- au moins une diode laser (1) apte à émettre une onde de pompe,
- un résonateur optique déclenché (22) apte à générer une onde laser comportant :
o une extrémité très fortement réfléchissante pour l'onde laser (12) et une extrémité partiellement réfléchissante (9) apte à transmettre l'onde laser à l'extérieur du résonateur optique déclenché (22) et à transmettre partiellement l'onde de pompe,
o un milieu amplificateur constitué d'une première fibre optique (6) apte à absorber l'onde de pompe et amplifier l'onde laser, disposé entre les deux extrémités réfléchissantes (9) et (12),
o un modulateur optique (13) apte à basculer d'un état bloquant à un état passant,
- un amplificateur optique constitué d'une deuxième fibre optique (10) disposé tel que l'extrémité partiellement réfléchissante (9) du résonateur optique déclenché (22) se situe entre les deux fibres optiques (6, 10), lesdites première (6) et deuxième (10) fibres optiques étant du type fibre optique double gaine présentant un coeur (30), une gaine de pompage (31), une gaine de confinement (32) et chacune une extrémité intérieure (18, 19) et une extrémité extérieure (17, 20)
- des premiers moyens de couplage optique (33, 34) aptes à coupler ladite onde de pompe à l'une des deux fibres optiques (6, 10) par leur extrémité extérieure (17, 20),
- des seconds moyens de couplage optique (35) disposés entre les deux fibres optiques (6, 10)
dans lequel :
- le modulateur optique (13) est un modulateur acousto-optique ou électro-optique,
- le coeur dopé (30) de la fibre optique (6, 10) par laquelle ladite onde de pompe est couplée par son extrémité extérieure (17, 20) est apte à absorber partiellement l'onde de pompe et à laisser une onde de pompe résiduelle à l'extrémité intérieure (18, 19) de ladite fibre optique (6, 10),
- les seconds moyens de couplage optique (35) sont aptes à assurer simultanément le couplage de l'onde de pompe résiduelle et le couplage de l'onde laser issue du résonateur optique déclenché (22), et situés à l'extrémité intérieure (18, 19) de l'autre des deux fibres optiques (6, 10),
- ladite deuxième fibre optique (10) présente une longueur supérieure à celle de la première fibre optique (6) la rendant apte à amplifier l'onde laser issue du résonateur optique déclenché (22).

2. Dispositif laser impulsionnel à fibre optique selon la revendication 1, **caractérisé en ce que** les extrémités intérieures (18, 19) des premières (6) et deuxièmes (10) fibres optiques, l'extrémité partiellement réfléchissante (9) et les seconds moyens de couplage optique (35) sont assemblés entre eux de façon à former un ensemble monolithique.

3. Dispositif laser impulsionnel à fibre optique selon la revendication 2, **caractérisé en ce que** les premières (6) et deuxièmes (10) fibres optiques sont formées d'une fibre optique unique dans laquelle l'extrémité partiellement réfléchissante (9) et les seconds moyens de couplage optique (35) sont gravés ou photoinscrits, formant deux parties de fibre optique (6, 10) distinctes de longueurs différentes.

4. Dispositif laser impulsionnel à fibre optique selon la revendication 3, **caractérisé en ce que** l'extrémité partiellement réfléchissante (9) et le modulateur optique (13) forment un modulateur intégré (16) dans les fibres optiques (6, 10) comprenant une commande électrique de façon à contrôler la réflectivité dudit modulateur, ledit modulateur intégré (16) étant disposé entre les premières (6) et deuxièmes (10) fibres optiques.

5. Dispositif laser impulsionnel à fibre optique selon l'une quelconque des revendications 1 à 4 **caractérisé en ce que** l'extrémité partiellement réfléchissante (9) comprend un réseau de Bragg.

6. Dispositif laser impulsionnel à fibre optique selon la revendication 5, **caractérisé en ce que** l'extrémité très fortement réfléchissante (12) et les premiers moyens de couplage optique (33, 34) forment un réflecteur total (15) intégré à l'extrémité externe (17) de la première fibre optique (6), ledit réflecteur total (15) comprenant un réseau de Bragg.

7. Dispositif laser impulsionnel à fibre optique selon la revendication 1, **caractérisé en ce que** les seconds moyens de couplage optique (35) sont des moyens mécaniques de maintien d'extrémité de fibre optique aptes à rapprocher les extrémités intérieures (18, 19) des deux fibres optiques (6, 10) qui se font face.

8. Dispositif laser impulsionnel à fibre optique selon l'une quelconque des revendications 1 à 7, **caractérisé en ce qu'**il comprend :
- deux diodes lasers (1) émettant chacune une onde de pompe et,
- deux premiers moyens de couplage optique (33, 34), l'un des premiers moyens de couplage optique (33) étant apte à coupler l'une des ondes de pompe sur l'extrémité extérieure (17) de la première fibre optique (6) et l'autre des premiers moyens de couplage optique (34) étant apte à coupler l'autre onde de pompe sur l'extrémité extérieure (20) de la deuxième fibre optique (10).

9. Dispositif laser impulsionnel à fibre optique selon l'une quelconque des revendications 1 à 8, **caractérisé en ce qu'**au moins une des deux fibres optiques (6, 10) est du type fibre photonique.

10. Dispositif laser impulsionnel à fibre optique selon l'une quelconque des revendications 1 à 9, **caractérisé en ce que** le coeur des premières (6) et deuxièmes (10) fibres optiques présente un diamètre supérieur à 30 µm.

11. Dispositif laser impulsionnel à fibre optique selon l'une quelconque des revendications 1 à 10, **caractérisé en ce qu'**il comprend un moyen polarisant et un moyen de stabilisation pour rigidifier les fibres optiques (6, 10) de façon à obtenir des impulsions lasers polarisées.

## Claims

1. High-power fiber optic pulsed laser device comprising:
- at least one laser diode (1) suitable for emitting a pump wave,
- a triggered optical resonator (22) suitable for generating a laser wave, comprising :
o a very strongly reflective end (12) for the laser wave and a partially reflective end (9) suitable for transmitting the laser wave outside of the triggered optical resonator (22) and for partially transmitting the pump wave,
o an amplifying medium consisting of a first optical fiber (6) suitable for absorbing the pump wave and for amplifying the laser wave, disposed between the two reflective ends (9) and (12),
o an optical modulator (13) suitable for switching from an off-state to a on-state,
- an optical amplifier consisting of a second optical fiber (10), disposed such that the partially reflective end (9) of the triggered optical resonator (22) is located between the two optical fibers (6, 10), said first (6) and second (10) optical fibers being of the double-sheathed optical fiber type with a core (30), a pumping sheath (31) and a confining sheath (32), and having each an inner end (18, 19) and an outer end (17, 20),
- first optical coupling means (33, 34) suitable for coupling said pump wave to one of the two optical fibers (6, 10) through the outer end (17, 20) thereof,
- second optical coupling means (35) disposed between the two optical fibers (6, 10),
wherein
- the optical modulator (13) is an acousto-optic modulator or an electro-optic modulator,
- the doped core (30) of the optical fiber (6, 10) through the outer end (17, 20) of which said pump wave is coupled is suitable for partially absorbing the pump wave and for leaving a residual pump wave at the inner end (18, 19) of said optical fiber (6, 10),
- the second optical coupling means (35) are suitable for providing simultaneously the coupling of the residual pump wave and the coupling of the laser wave emerging from the triggered optical resonator (22), and located at the inner end (18, 19) of the other of the two optical fibers (6, 10),
- said second optical fiber (10) has a length greater than that of the first optical fiber (6), which makes it suitable for amplifying the laser wave emerging from the triggered optical resonator (22).

2. The high-power fiber optic pulsed laser device according to claim 1, **characterized in that** inner ends (18, 19) of the first (6) and second (10) optical fibers, the partially reflective end (9) and the second optical coupling means (35) are assembled together so as to form a monolithic assembly.

3. The high-power fiber optic pulsed laser device according to claim 2, **characterized in that** the first (6) and second (10) optical fibers are made of a single optical fiber in which the partially reflective end (9) and the second optical coupling means (35) are etched or photoengraved, forming two separate optical fiber parts (6, 10) with different lengths.

4. The high-power fiber optic pulsed laser device according to claim 3, **characterized in that** the partially reflective end (9) and the optical modulator (13) form a integrated modulator (16) in the optical fibers (6, 10), comprising an electrical control so as to control the reflectivity of said modulator, said integrated modulator (16) being disposed between the first (6) and second (10) optical fibers.

5. The high-power fiber optic pulsed laser device according to any one of claims 1 to 4, **characterized in that** the partially reflective end (9) comprises a Bragg grating.

6. The high-power fiber optic pulsed laser device according to claim 5, **characterized in that** the very strongly reflective end (12) and the first optical coupling means (33, 34) form a total reflector (15) integrated to the outer end (17) of the first optical fiber (6), said total reflector (15) comprising a Bragg grating.

7. The high-power fiber optic pulsed laser device according to claim 1, **characterized in that** the second optical coupling means (35) are mechanical optical-fiber-end fastening means suitable for bringing closer the opposite inner ends (18, 19) of the two optical fibers (6, 10).

8. The high-power fiber optic pulsed laser device according to any one of claims 1 to 7, **characterized in that** it comprises:
- two laser diodes (1) each emitting a pump wave, and
- two first optical coupling means (33, 34), one of the first optical coupling means (33) being suitable for coupling one of the pump waves to the outer end (17) of the first optical fiber (6) and the other of the first optical coupling means (34) being suitable for coupling the other pump wave to the outer end (20) of the second optical fiber (10).

9. The high-power fiber optic pulsed laser device according to any one of claims 1 to 8, **characterized in that** at least one of the two optical fibers (6, 10) is of the photonic fiber type.

10. The high-power fiber optic pulsed laser device according to any one of claims 1 to 9, **characterized in that** the cores of the first (6) and second (10) optical fibers have a diameter larger than 30 µm.

11. The high-power fiber optic pulsed laser device according to any one of claims 1 to 10, **characterized in that** it comprises a polarizing means and a stabilizing means to stiffen the optical fibers (6, 10) so as to obtain polarized laser pulses.

## Patentansprüche

1. Gepulste faseroptische Laservorrichtung mit hoher Ausgangsleistung, umfassend:
- mindestens eine Laserdiode (1), die eine Pumpwelle entsenden kann,
- einen gepulsten optischen Resonator (22), der eine Laserwelle erzeugen kann, umfassend:
* ein sehr stark reflektierendes Ende für die Laserwelle (12) und ein teilweise reflektierendes Ende (9), das die Laserwelle außerhalb des gepulsten optischen Resonators (22) und teilweise die Pumpwelle übertragen kann,
* ein Verstärkungsmedium, das von einer ersten optischen Faser (6) gebildet ist, die die Pumpwelle absorbieren und die Laserwelle verstärken kann, und das zwischen den beiden reflektierenden Enden (9) und (12) angeordnet ist,
* einen optischen Modulator (13), der von einem Blockierungszustand in einen Durchgangszustand schwenken kann,
- einen optischen Verstärker, der von einer zweiten optischen Faser (10) gebildet ist, der derart angeordnet ist, dass das teilweise reflektierende Ende (9) des gepulsten optischen Resonators (22) zwischen den beiden optischen Fasern (6, 10) angeordnet ist, wobei die erste (6) und die zweite (10) optische Faser vom Typ optische Faser mit doppelter Hülle sind, die einen Kern (30), eine Pumphülle (31), eine Eingrenzungshülle (32) und jeweils ein inneres Ende (18, 19) und ein äußeres Ende (17, 20) aufweist,
- erste optische Kopplungsmittel (33, 34), die die Pumpwelle mit einer der beiden optischen Fasern (6, 10) mit ihrem äußeren Ende (17, 20) koppeln können,
- zweite optische Kopplungsmittel (35), die zwischen den beiden optischen Fasern (6, 10) angeordnet sind,
wobei:
- der optische Modulator (13) ein aktustischoptischer oder elektrisch-optischer Modulator ist,
- der Kern (30), der mit der optischen Faser (6, 10) versehen ist, über die die Pumpwelle mit ihrem äußeren Ende (17, 20) gekoppelt ist, ist geeignet, teilweise die Pumpwelle zu absorbieren und eine Restpumpwelle am inneren Ende (18, 19) der optischen Faser (6, 10) übrig zu lassen,
- die zweiten optischen Kopplungsmittel (35) geeignet sind, gleichzeitig die Kopplung der Restpumpwelle und die Kopplung der vom gepulsten optischen Resonator (22) kommenden Laserwelle zu gewährleisten, und sich am inneren Ende (18, 19) der anderen der beiden optischen Fasern (6, 10) befinden,
- die zweite optische Faser (10) eine größere Länge als jene der ersten optischen Faser (6) aufweist, wodurch sie dazu geeignet ist, die von dem gepulsten optischen Resonator (22) kommende Laserwelle zu verstärken.

2. Gepulste faseroptische Laservorrichtung nach Anspruch 1, **dadurch gekennzeichnet, dass** die inneren Enden (18, 19) der ersten (6) und zweiten (10) optischen Fasern, das teilweise reflektierende Ende (9) und die zweiten optischen Kopplungsmittel (35) miteinander derart verbunden sind, dass sie eine monolithische Einheit bilden.

3. Gepulste faseroptische Laservorrichtung nach Anspruch 2, **dadurch gekennzeichnet, dass** die ersten (6) und zweiten (10) optischen Fasern von einer einzigen optischen Faser gebildet sind, bei der das teilweise reflektierende Ende (9) und die zweiten optischen Kopplungsmittel (35) graviert und photobeschriftet sind, wodurch zwei getrennte Teile einer optischen Faser (6, 10) mit unterschiedlichen Längen gebildet werden.

4. Gepulste faseroptische Laservorrichtung nach Anspruch 3, **dadurch gekennzeichnet, dass** das teilweise reflektierende Ende (9) und der optische Modulator (13) einen Modulator (16) bilden, der in die optischen Fasern (6, 10) integriert ist, umfassend eine elektrische Steuerung, so dass die Reflexionsfähigkeit des Modulators kontrolliert wird, wobei der integrierte Modulator (16) zwischen den ersten (6) und zweiten (10) optischen Fasern angeordnet ist.

5. Gepulste faseroptische Laservorrichtung nach einem der Ansprüche 1 bis 4, **dadurch gekennzeichnet, dass** das teilweise reflektierende Ende (9) ein Bragg-Gitter umfasst.

6. Gepulste faseroptische Laservorrichtung nach Anspruch 5, **dadurch gekennzeichnet, dass** das sehr stark reflektierende Ende (12) und die ersten optischen Kopplungsmittel (33, 34) einen Totalreflektor (15) bilden, der in das äußere Ende (17) der ersten optischen Faser (6) integriert ist, wobei der Totalreflektor (15) ein Bragg-Gitter umfasst.

7. Gepulste faseroptische Laservorrichtung nach Anspruch 1, dadurch gekenntzeichnet, dass die zweiten optischen Kopplungsmittel (35) mechanische Haltemittel am Ende der optischen Faser sind, die die inneren Enden (18, 19) der beiden optischen Fasern (6, 10), die einander gegenüber liegen, annähern können.

8. Gepulste faseroptische Laservorrichtung nach einem der Ansprüche 1 bis 7, **dadurch gekennzeichnet, dass** sie umfasst:
- zwei Laserdioden (1), die jeweils eine Pumpwelle entsenden, und
- zwei erste optische Kopplungsmittel (33, 34), wobei eines der ersten optischen Kopplungsmittel (33) geeignet ist, eine der Pumpwellen mit dem äußeren Ende (17) der ersten optischen Faser (6) zu koppeln, und wobei das andere der optischen Kopplungsmittel (34) geeignet ist, die andere Pumpwelle mit dem äußeren Ende (20) der zweiten optischen Faser (10) zu koppeln.

9. Gepulste faseroptische Laservorrichtung nach einem der Ansprüche 1 bis 8, **dadurch gekennzeichnet, dass** mindestens eine der beiden optischen Fasern (6, 10) vom Typ Photonenfaser ist.

10. Gepulste faseroptische Laservorrichtung nach einem der Ansprüche 1 bis 9, dadurch gekenntzeichnet, dass der Kern der ersten (6) und zweiten (10) optischen Fasern einen Durchmesser über 30 µm aufweist.

11. Gepulste faseroptische Laservorrichtung nach einem der Ansprüche 1 bis 10, **dadurch gekennzeichnet, dass** sie ein Polarisationsmittel und ein Stabilisationsmittel umfasst, um die optischen Fasern (6, 10) zu viersteifen, um polarisierte Laserimpulse zu erhalten.
